# EUROPEAN PATENT SPECIFICATION

(11) **EP 2 383 113 B1**
(45) Date of publication and mention of the grant of the patent: **04.05.2016**
(21) Application number: 09834550.7
(22) Date of filing: 10.03.2009
(51) Int. Cl.: H05K 3/02, H05K 3/46

(54) **METAL FOIL WITH CARRIER**
METALLFOLIE MIT TRÄGER
FEUILLE MÉTALLIQUE AVEC SUPPORT

(30) Priority: 24.12.2008 JP 2008327448
(43) Date of publication of application: 02.11.2011
(73) Proprietor: JX Nippon Mining & Metals Corporation, Tokyo 100-8164 (JP)
(72) Inventor: TAKAMORI, Masayuki, Tokyo 100-8164 (JP)
(74) Representative: Hoarton, Lloyd Douglas Charles
(86) International application number: PCT/JP2009/054481
(87) International publication number: WO 2010/073744

(56) References cited:
- JP-A- 10 291 080
- JP-A- 11 277 562
- JP-A- 2001 068 804
- JP-A- 2002 134 877
- JP-A- 2002 134 877
- US-A- 5 942 314
- US-B1- 6 606 792

## Description

### TECHNICAL FIELD

The present invention relates to a copper foil with a carrier used in producing a single-sided or multilayer laminated plate of two or more layers for use in a print wiring board.

### BACKGROUND ART

A typical example of a multilayer laminated body is a printed circuit board. Generally, a printed circuit board is basically configured from a dielectric material referred to as a "prepreg" that is obtained by impregnating synthetic resin in a base material such as a synthetic resin plate, glass plate, nonwoven glass fabric or paper.

A sheet such as a copper or copper alloy foil having electrical conductivity is bonded to the prepreg surface, both of the front and back surfaces. A laminate that is assembled as described above is generally referred to as a CCL, namely, a Copper Clad Laminate material. When copper foils are multi-layered on the CCL material with use of the prepreg, this is referred to as a multilayer board.

Other foils made of aluminum, nickel, zinc or the like may also be used in substitute for the copper or copper alloy foil. The foil thickness is roughly 5 to 200 µm.

In the foregoing process, a copper foil with a carrier is used for the purpose of preventing the adhesion of foreign matter on the surface of the copper foil and for the purpose of improving the handling ability.

For example, in the method of producing a four-layer substrate using a conventionally known copper foil with a carrier (refer to Patent Documents 2, 3, 4), an ultrathin copper foil to which a carrier is peelably bonded is mounted on a stainless pressing plate called "mirror plate" having a flat pressing surface with a thickness of 0.2 to 2 mm so that the M surface is on top ('M surface' as used herein represents 'rough surface', and both of the expressions are used interchangeably hereinafter), subsequently a prescribed number of prepregs, subsequently a printed circuit board in which a circuit is formed on a CCL material referred to as the inner layer core, subsequently a prepreg, and subsequently an ultrathin copper foil to which a carrier is peelably bonded are mounted so that the M surface is at the bottom, and by laminating these in the order of the mirror plate, an assembled unit configured from one set of a four-layer substrate material is thereby complete.

Subsequently, these units, so-called "pages", are repeatedly laminated 2 to 10 times to configure a press assembly, so-called "book". Subsequently, the foregoing book is placed on a hot plate in the hot press and subject to compression molding at a prescribed temperature and pressure to produce a laminated plate. Substrates with four or more layers can be produced by a similar process by increasing the number of layers of the inner layer core.

Here, with the copper foil with a carrier to be used, since the ultrathin copper foil and the carrier are bonded across the entire surface, there is a problem in that considerable force is required for the worker to peel the carrier after lamination, and this is troublesome for the worker. In addition, as described above, upon performing the lay-up operation, lamination assembly operation, in other words, the worker needs to alternatively repeat the process of lamination so that the M surface of the copper foil is on top or the M surface is at the bottom, and there is a problem in that the work efficiency will deteriorate. Moreover, since the copper foil and the carrier are of the same size, it is difficult to peel one copper foil at a time during the lay-up, which is also a problem in that the workability deteriorates on this point.

And, as described in Patent Document 1, upon producing a circuit board using CAC having a structure in which a copper foil is bonded to the front and back surfaces of an aluminum plate, an aluminum plate (JIS#5182) is used as a part of the CAC material. However, since the linear expansion coefficient of the aluminum plate is 23.8 × 10⁻⁶/°C and great compared to 16.5 × 10⁻⁶/°C of the copper foil as the constituent material of the substrate and the polymerized prepreg (C stage: 12 to 18 × 10⁻⁶/°C), a phenomenon of scaling change where the board size before and after pressing is different than the designed size will occur. This will lead to the misalignment of the circuit in the in-plane direction, and there is a problem in that this will become a cause for deteriorating the production yield.

The linear expansion coefficient at normal temperature of the various materials used in the print wiring board is as follows. It is evident that the linear expansion coefficient of the aluminum plate is fairly greater than the other materials.
- Copper foil: 16.5 (× 10⁻⁶/°C)
- SUS304: 17.3 × 10⁻⁶/°C
- SUS301: 15.2 × 10⁻⁶/°C

SUS630: 11.6 × 10⁻⁶/°C
Prepreg (C stage): 12 to 18 × 10⁻⁶>/°C
Aluminum plate (JIS#5182): 23.8 × 10⁻⁶/°C

Not directly related to the present invention, there are the following documents as examples related to an ultrathin copper foil with a carrier (Patent Document 2, Patent Document 3 and Patent Document 4).
[Patent Document 1] Japanese Patent No. 3100983
[Patent Document 2] Japanese Published Unexamined Application No. 2005-161840
[Patent Document 3] Japanese Published Unexamined Application No. 2007-186797
[Patent Document 4] Japanese Published Unexamined Application No. 2001-140090

US 5,942,314 describes a method and apparatus for ultrasonically welding a strip of copper foil to a second strip of supporting metal, to provide a metal foil with a carrier.

JP 2002 134877 A describes a method for securing and processing a thin film material.

### DISCLOSURE OF THE INVENTION

The present invention was devised in view of the foregoing circumstances, and relates to a copper foil with a carrier that is used in producing a single-sided or multilayer laminated body of two or more layers for use in a print wiring board, and particularly relates to a copper foil with a carrier to be used upon producing a laminated plate. Thus, an object of this invention is to realize improvement in the handling ability in the production process of a printed board and cost reduction based on an improved production yield.

As a result of intense study to achieve the foregoing object, the present inventors discovered that the workability will improve by causing the carrier supporting the copper foil to be larger than the area of the copper foil.

Based on this discovery, the present invention provides a metal foil with carrier as claimed.

A preferred feature of the metal foil with a carrier is that it is a laminated body in which a carrier A and a metal foil B are placed alternately, wherein the metal foil with a carrier comprises a structure where the adjoining carrier wherein the metal foil with a carrier comprises a structure where the adjoining carrier A has an area which covers the entire surface of the metal foil B, and the edge of the carrier A protrudes partially or entirely from the metal foil B.

Accordingly, it is therefore easy to differentiate a laminated pair of the carrier A and the metal foil B from a similar type of laminated pair of the carrier A and the metal foil B, and the worker's handling performance will improve. Moreover, even upon peeling the carrier from the copper foil, peeling is easy since there is a part (edge or end) which differs in dimension.

Although it is optional to mutually face the glossy surface of the carrier A and the glossy surface of the metal foil B, when it is placed this way, the work efficiency will improve dramatically since the worker no longer needs to perform operations of placing the M surface of the copper foil on bottom or top. This is because the glossy surface or rough surface or the carrier or the glossy surface or the rough surface of the copper foil can be arbitrarily used for different purposes.

Although the use of a copper foil as the carrier is optional, if the carrier is made of copper foil, the linear expansion coefficient will be of the same level as the copper foil as the constituent material of the substrate and the polymerized prepreg, and, since the misalignment of the circuit will not occur, this invention yields a superior effect of minimizing defective goods and thereby improving the production yield.

The copper foil with a carrier of the present invention has a structure where the glossy surface of the metal foil B is subject to ultrasonic bonding so as to come in contact with the carrier A made of aluminum or copper or copper alloy. The peeling of the aluminum layer after lamination is facilitated, and an effect is yielded in that it is possible to prevent the peeled copper foil from breaking and the aluminum carrier from remaining on the copper foil.

Particularly, it is effective if the carrier A is a rolled copper foil or an electrolytic copper foil, and the glossy surface of the copper foil B is subject to ultrasonic bonding so as to come in contact with the roughened surface of the rolled copper foil or the rough surface or the roughened surface of the electrolytic copper foil.

Moreover, based on the selection of the material of the carrier A and the metal foil B; in particular, by selecting the material and the surface state, the peelability upon separating the bond can be improved. Accordingly, an effect is yielded in that these can be arbitrarily combined and used.

### BRIEF DESCRIPTION OF THE DRAWINGS

[Fig. 1] Fig. 1 is a conceptual explanatory diagram of the metal foil with a carrier of the present invention comprising a structure in which a copper foil, a prepreg, a core material, and a copper foil are disposed in order, and the edge of the carrier A partially protrudes from the metal foil B.
[Fig. 2] Fig. 2 is an explanatory diagram of the copper foil with a carrier of the present invention in which the glossy surface (S surface) of the carrier A and the glossy surface (S surface) of the metal foil B are mutually laminated.
[Fig. 3] Fig. 3 is an explanatory diagram showing the bond part of the carrier A and the metal foil B of the present invention.
[Fig. 4] Fig. 4 is an explanatory diagram showing a state of forming, based on hot pressing, a copper foil layer of L2 comprising a structure in which a copper foil, a prepreg, a core material, and a copper foil are disposed in order, and the edge of the carrier A partially protrudes from the metal foil B.
[Fig. 5] Fig. 5 is an explanatory diagram showing a state of forming a copper foil layer as the outermost layer by hot pressing a copper foil with a carrier comprising a structure in which a copper foil, a prepreg, a core material, and a copper foil are placed in order, and the edge of the carrier A partially protrudes from the metal foil B, and in which the glossy surface of the carrier A and the glossy surface of the metal foil B are mutually bonded.

### KEY TO THE FIGURES

- 1: = B
- 2: = A
- 3: = B
- 4: = A
- 5: = Metal foil S surface
- 6: = B
- 7: = Metal foil M surface
- 8: = A
- 9: = Carrier S surface
- 10: = Carrier M surface
- 11: = Welding
- 12: = Metal foil with carrier
- 13: = Mirror plate
- 14: = Core material
- 15: = Laminated mold
- 16: = Mirror plate
- 17: = Prepreg
- 18: = Metal foil with carrier
- 19: = Mirror plate
- 20: = Core material
- 21: = Laminated mold
- 22: = Metal foil with carrier
- 23: = Mirror plate
- 24: = Prepreg

### BEST MODE FOR CARRYING OUT THE INVENTION

Generally, a printed circuit board is basically configured from a dielectric material referred to as a "prepreg" that is obtained by impregnating synthetic resin in a base material such as a synthetic resin plate, glass plate, nonwoven glass fabric or paper. A sheet such as a copper or copper alloy foil having electrical conductivity is bonded with the prepreg in-between. A laminate that is assembled as described above is generally referred to as a CCL, namely, Copper Clad Laminate material. In substitute for the foregoing copper or copper alloy foil used generally as the CCL material, other foils made of aluminum, nickel, zinc or the like are sometimes used. In the foregoing case, the foil thickness is roughly 5 to 200 µm.

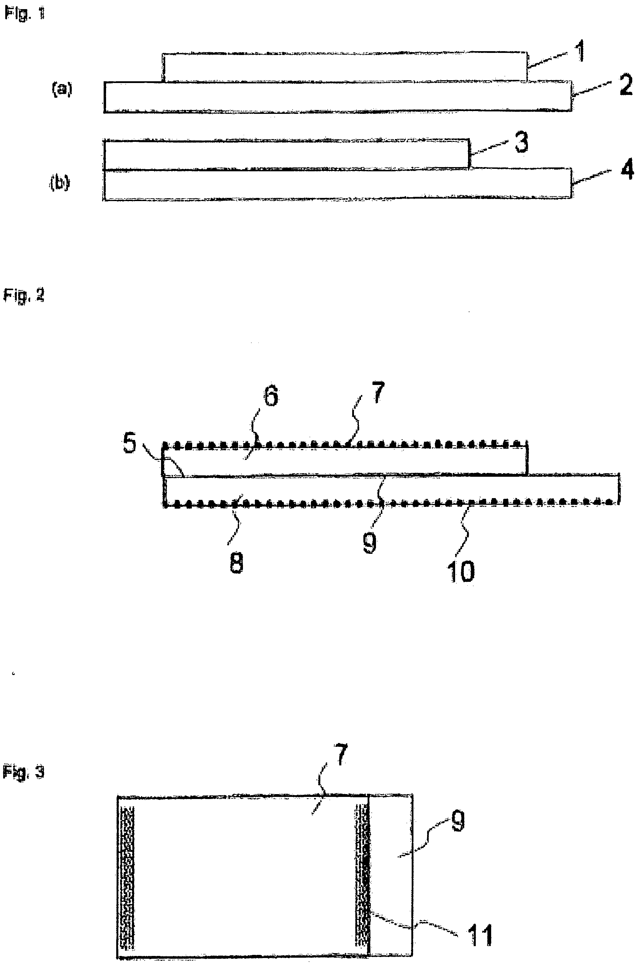

The metal foil with a carrier of the present invention is shown in Fig. 1. With the metal foil with a carrier shown in Fig. 1, the carrier is shown as A and the metal foil is shown as B. Although they look similar to the foregoing CCL material structurally, as for the metal foil with a carrier of the present invention, since the carrier A and the metal foil B are separated eventually, they can be easily peeled mechanically. On this point, since the CCL material cannot be peeled, the structure and function thereof are completely different from the present invention.

In Fig. 1, in both cases the carrier A is larger than the area of the metal foil B, and the case of Fig. 1 (a) shows a structure where two opposing sides protrude farther than the metal foil B, and the case of Fig. 1 (b) shows a structure where one side is protruding farther than the metal foil B.

The amount of protrusion can be suitably selected according to the workability, entirely as one thinks proper. This range is approximately 1 cm to 10 cm; however, it goes without saying that the protrusion may be prepared beyond the foregoing range. Although the remaining sides of the carrier A are desirably aligned with the metal foil B, this may be arbitrarily adjusted or selected according to the objective of the production process.

This is because the primary object of the present invention is to improve the handling performance of workers as a whole by realizing a structure where the carrier A protrudes from the metal foil B by enlarging the area of the carrier A to be greater than the metal foil B, facilitating the differentiation of a laminated pair of the carrier A and the metal foil B from a similar type of laminated pair of the carrier A and the metal foil B, and facilitating the peeling process by providing a part (edge or end) which differs in dimension upon peeling the carrier A from the metal foil B.

In normal circumstances, the carrier A and the metal foil B are formed in a quadrilateral, namely, a rectangular or a square. Although this shape is selectable so as long as it is convenient in the handling during its manufacture, a square or a rectangular is generally used.

In addition, from the perspective of handling in the layering process, desirably one side of the carrier A and one side of the metal foil B are mutually aligned, or two adjoining sides or two opposing sides of the carrier A and the metal foil B are mutually aligned. The foregoing selection is also optional.

With the carrier-attached metal foil of the present invention, a preferred mode is the metal foil B being a copper foil or a copper alloy foil, and the carrier A being a copper foil or a copper alloy foil.

The carrier-attached metal foil of the present invention yields numerous advantages as a result of the carrier A and the metal foil B respectively having a glossy surface, and the respective glossy surfaces being laminated to face each other, and this is also a preferred mode of lamination.

Fig. 2 shows a metal foil with a carrier with a structure where the carrier A protrudes from the metal foil B by enlarging the carrier A to have a greater area than the metal foil B, and the respective glossy surfaces are laminated to face each other. In Fig. 2, the upper metal foil B has an upper surface using a copper foil as the M surface and a lower surface as the S surface, and the lower carrier A has an upper surface as the S surface and the lower surface as the M surface, and the S surfaces thereof are mutually bonded.

In the foregoing case, if the carrier A and the metal foil B are foils made of the same material, the respective front and back glossy surfaces of the carrier A and the metal foil B after peeling can be used without having to perform any reversing operations. This enables the considerable improvement in workability.

Conventionally, when a worker had to place the M surface of the copper foil on top and place the M surface on bottom in the layup (lamination) process and alternately repeat this process, there was a problem in that the work efficiency would deteriorate, but the present invention yields an effect of resolving the problem at once.

As described above, since the present invention has a structure where the carrier A protrudes from the metal foil B by enlarging the area of the carrier A to be greater than the metal foil B, it is possible to facilitate the differentiation of a laminated pair of the carrier A and the metal foil B from a similar type of laminated pair of the carrier A and the metal foil B, and facilitate the peeling process by providing a part (edge or end) which differs in dimension upon peeling the carrier A from the metal foil B. In summary, the present invention yields an effect of considerably improving the handling performance of workers compared to conventional processes, and the prominence of the present invention is evident.

The carrier A and the metal foil B are mutually bonded by ultrasonic bonding to avoid misalignment.

Fig. 3 shows an example where the glossy surface of the carrier (for example, copper foil) A is placed on top and the glossy surface of the metal (copper) foil B is placed on bottom and welded based on ultrasonic welding. In Fig. 3, a part of the glossy surface of the carrier (for example, copper foil) A is exposed on the right side. And the rough surface of the metal (copper) foil B can be seen as the back side.

Since the carrier A and the metal foil B are fixed as described, the worker's layup (lamination) process is effectively improved. Moreover, since the surface is not fixed entirely, the peeling, or scaling process after lamination is also facilitated.

As the metal foil B, a copper foil or a copper alloy foil is a typical example and most favorable, but foils of aluminum, nickel, zinc and the like may also be used. Similarly, a foil of the same material as the metal foil B can be used as the carrier A.

In the case of a copper foil or a copper alloy foil, an electrolytic foil or a rolled foil with a thickness of 5 to 120 µm can be used.

Moreover, the coefficient of thermal expansion of the carrier is desirably within the range of +10% and -30% of the coefficient of thermal expansion of the metal foil B. Consequently, it is possible to effectively prevent the misalignment of the circuit caused by the difference in thermal expansion, and thereby minimize defective goods and improve the production yield.

Since the carrier A and the metal foil B are usually mechanically peeled before the process of plating or etching or the like, the peel strength thereof is desirably 1 g/cm or more and 1 kg/cm or less. Moreover, the peeling surface is desirably the boundary of the carrier A and the metal foil B. The residue of other material will require a removal work thereof and cause the overall process to become complicated, and must be avoided.

### [Examples]

The Examples are now explained. Note that these Examples are presented for facilitating the understanding of the invention, and the invention is not limited to the Examples.

### (Example 1)

A prepreg prepared from epoxy resin was used as the resin material. An intended number of prepregs were laminated on the metal foil with a carrier, a two-layer printed circuit board referred to as an inner layer core was subsequently laminated thereon, a prepreg was subsequently laminated thereon, and a metal foil with a carrier was further formed thereon, in the foregoing order, in order to complete one set of a four-layer substrate material assembly unit.

Subsequently, this unit called "page" was repeatedly laminated about 10 times to configure a press assembly called "book".

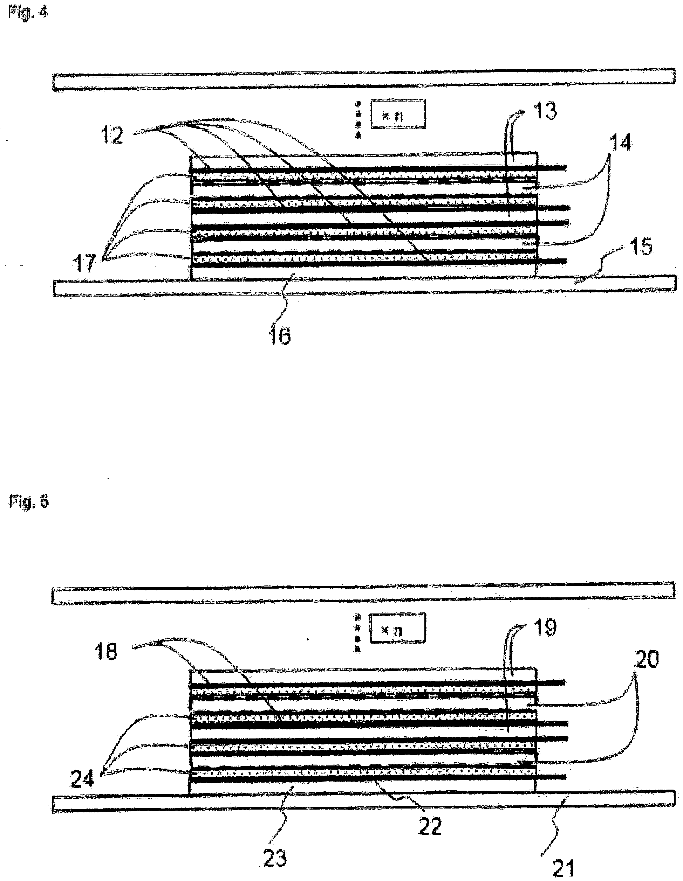

The present example is unique with respect to the structure of the metal foil with a carrier, and comprises a structure where the carrier A protrudes from the metal foil B. Fig. 4 shows this structure.

Fig. 4 shows a case of forming a four-layer substrate unit called "page" obtained by laminating, in order, a metal foil with a carrier, intended number of prepregs, two-layer printed circuit board as an inner layer core, prepreg, and further a metal foil with a carrier. Fig. 4 shows a state of further stacking this with a mirror plate (intermediate plate) interposed therebetween (2 levels in Fig. 4). In normal circumstances, this is repeated about 10 times to prepare an assembly called "book" to be pressed. Note that "× n" in Fig. 4 shows a multilayer (n = 1, 2, 3...n).

These laminated bodies are mostly aligned, but the portion protruding to the right side of the foregoing unit is the characteristic point of this Example. This is the carrier A that protrudes from the metal foil B. A rolled copper alloy foil of 35 µm was used as the carrier A (in this example, brass containing 65% copper and 35% zinc was used), a rolled copper foil of 5 µm was used as the metal foil B, and these were bonded using an epoxy adhesive.

The bond location was the position shown in Fig. 3. Note that the bond surface of the carrier A and the metal foil B was the glossy surface of the carrier A and the rough surface of the metal foil B.

At the stage of preparing this set of four-layer substrate material assembly unit, it was necessary to reverse the metal foil with a carrier, but since the metal foil with a carrier comprises a structure where the carrier A protrudes from the metal foil B by enlarging the area of the carrier A to be greater than the metal foil B, it was possible to facilitate the differentiation of a laminated pair of the carrier A and the metal foil B from a similar type of laminated pair of the carrier A and the metal foil B, and the reversing operation was easy. Thus, it was possible to seek much improvement in the work efficiency at the previous step of preparing the assembly to be pressed.

This book was thereafter set in a hot press and subject to compression molding at a prescribed temperature and pressure to produce a four-layer substrate. Note that substrates with four or more layers can be generally produced by a similar process by increasing the number of layers of the inner layer core.

The laminated plate prepared as described above was formed into a completed product by peeling and separating the carrier from copper foil, and subsequently forming a circuit by undergoing plating process and/or etching process. Since the entire surface of the metal foil B is supported with the carrier A, the metal foil was completely free of wrinkles during the lamination.

In addition, since a copper alloy foil was used as the carrier A and copper was used as the metal foil B, the linear expansion coefficient was basically the same level as the copper foil as the constituent material of the substrate and the polymerized prepreg. Thus, the misalignment of the circuit did not occur. Accordingly, it was possible to minimize defective goods and thereby improve the production yield compared to cases of using a conventional CAC.

Example 1 is unique with respect to the structure of the carrier A that protrudes from the metal foil B, and it should be easy to understand that the advantage of this structure is not affected by the material or thickness of the metal foil B and the carrier A.

### (Example 2)

As with Example 1, a prepreg prepared from epoxy resin was used as the resin material. An intended number of prepregs were laminated on the metal foil with a carrier, a two-layer printed circuit board referred to as an inner layer core was subsequently laminated thereon, a prepreg was subsequently laminated thereon, and a metal foil with a carrier was further formed thereon, in the foregoing order, in order to complete one set of a four-layer substrate material assembly unit.

Subsequently, this unit called "page" was repeatedly laminated about 10 times to configure a press assembly called "book".

The present invention is unique with respect to the structure of the metal foil with a carrier, and comprises a structure where the carrier A protrudes from the metal foil B. Copper was used for both the carrier A and the metal foil B. Fig. 5 shows this structure. Fig. 5 may appear to have the same structure as Fig. 4, but there are differences that are not shown, and, as described later, there is a difference in the materials that are used as the carrier A and the metal foil B, and the mode of these layered materials. The explanation of Fig. 5 is the same as Example 1.

Fig. 5 shows a case of forming a four-layer substrate unit called "page" obtained by laminating, in order, a metal foil with a carrier, intended number of prepregs, two-layer printed circuit board as an inner layer core, prepreg, and further a metal foil with a carrier. Fig. 5 shows a state of further stacking this with a mirror plate (intermediate plate) interposed therebetween (2 levels in Fig. 5). In normal circumstances, this is repeated about 10 times to prepare an assembly called "book" to be pressed. Note that "x n" in Fig. 5 shows a multilayer (n = 1, 2, 3...n).

These laminated bodies are mostly aligned, but the portion protruding to the right side of the foregoing unit. This is the carrier A that protrudes from the metal foil B. Moreover, a roller copper foil was used as the carrier A and an electrolytic copper foil was used as the metal foil B. Subsequently, the respective glossy surfaces were mutually bonded with the ultrasonic welding method. The bond location was the position shown in Fig. 3. As described above, it was possible to seek considerable improvement in the work efficiency at the previous step of preparing the assembly to be pressed.

And, the foregoing book was placed in the hot press and subject to compression molding at a prescribed temperature and pressure to produce a four-layer substrate. Generally, substrates with four or more layers can also be produced by a similar process by increasing the number of layers of the inner layer core.

The printed circuit board of a multilayer structure with a prepreg prepared as described above was formed into a completed product by forming a circuit by undergoing plating process and/or etching process, and further peeling and separating the carrier A and the copper foil B. The metal foil was completely free of wrinkles during the foregoing lamination.

In addition, since a copper foil is used as the carrier A as well as the metal foil B, the linear expansion coefficient will basically be the same level as the copper foil as the constituent material of the substrate and the polymerized prepreg. Thus, the misalignment of the circuit will not occur. Accordingly, it was possible to minimize defective goods and thereby improve the production yield compared to cases of using a conventional CAC.

### (Example 3)

The roughened surface of the rolled copper foil of the carrier A and the S surface of the electrolytic copper foil of the metal foil B were bonded using the ultrasonic welding method. Otherwise, a book was prepared as with Example 2, and the foregoing book was placed in a hot press and subject to compression molding at a prescribed temperature and pressure to produce a four-layer substrate. The laminated plate prepared as described above was formed into a completed product by forming a circuit by undergoing plating process and/or etching process, and further peeling and separating the carrier and the copper foil.

With this peeling and separation, the configuration of this Example did not result in any rupture of the copper foil or residual copper carrier on the copper foil, though in the case of Example 2, the copper foil after the peeling and separation had slightly ruptured and the copper carrier slightly remained on the copper foil.

Accordingly, it was discovered that it is extremely effective to bond the roughened surface of the rolled copper foil of the carrier A and the S surface of the electrolytic copper foil of the metal foil B using the ultrasonic welding method.

### (Example 4)

An electrolytic copper foil was used as the carrier A. The electrolytic copper foil has a rough surface and a glossy surface, and here, the rough surface of the electrolytic copper foil and the S surface of the electrolytic copper foil of the metal foil B were bonded using the ultrasonic welding method. Otherwise, a book was prepared as with Example 3, and the foregoing book was placed in a hot press and subject to compression molding at a prescribed temperature and pressure to produce a four-layer substrate. The laminated plate prepared as described above was formed into a completed product by forming a circuit by undergoing plating process and/or etching process, and further peeling and separating the carrier and the copper foil.

The configuration of this Example did not result in any rupture of the copper foil or residual copper carrier on the copper foil, as with Example 3.

Accordingly, it was discovered that it is extremely effective to bond the rough surface of the electrolytic copper foil of the carrier A and the S surface of the electrolytic copper foil of the metal foil B using the ultrasonic welding method.

### (Example 5)

An aluminum rolled foil was used as the carrier A, and it was bonded with the S surface of the electrolytic copper foil of the metal foil B using the ultrasonic welding method. Otherwise, a book was prepared as with Example 2, and the foregoing book was placed in a hot press and subject to compression molding at a prescribed temperature and pressure to produce a four-layer substrate. The laminated plate prepared as described above was formed into a completed product by forming a circuit by undergoing plating process and/or etching process, and further peeling and separating the carrier and the copper foil.

The configuration of this Example did not result in any rupture of the copper foil or residual copper carrier on the copper foil in the peeling and separation process, as with Example 3.

A copper foil or a copper alloy foil is normally used as the metal foil B, but it goes without saying that other metal foils may be used as the metal foil B. Moreover, as the carrier A, a copper foil or a copper alloy foil or an aluminum foil is used. In the foregoing case, rolled aluminum foil is generally used.

As the copper foil, there is a rolled copper foil and an electrolytic copper foil, but either may be used as the carrier A of the present invention. The glossy surface of the rolled copper foil and the electrolytic copper foil may be used, or the rough surface thereof may be used.

In the case of a rolled copper foil, since the rolled surface is the glossy surface, this may be used upon performing roughening treatment thereto. In the case of an electrolytic copper foil, the glossy surface or the rough surface may be further subject to roughening treatment and used as the carrier A.

Based on the selection of the material of the carrier A and the metal foil B; particularly, by selecting the material and the surface state, the peelability upon separating the bond can improve. Thus, these can be arbitrarily combined and used.

### INDUSTRIAL APPLICABILITY

The metal foil with a carrier of the present invention is characterized in that it is a laminated body in which a carrier A and a metal foil B are placed alternately, wherein the metal foil with a carrier comprises a structure where the adjoining carrier A has an area which covers the entire surface of the metal foil B, and the edge of the carrier A protrudes partially or entirely from the metal foil B. Thus, it is therefore easy to differentiate a laminated pair of the carrier A and the metal foil B from a similar type of laminated pair of the carrier A and the metal foil B, and the worker's handling performance will improve. Moreover, even upon peeling the carrier from the copper foil, peeling is easy since there is a part (edge or end) which differs in dimension.

Although it is optional to mutually face the glossy surface of the carrier A and the glossy surface of the metal foil B, when it is placed this way, the work efficiency will improve dramatically since the worker no longer needs to perform operations of placing the M surface of the copper foil on bottom or top.

In addition, although the use of a copper foil as the carrier is optional, if the carrier is made of copper foil, the linear expansion coefficient will be of the same level as the copper foil as the constituent material of the substrate and the polymerized prepreg, and, since the misalignment of the circuit will not occur, the present invention yields a superior effect of minimizing defective goods and thereby improving the production yield.

Significant advantages are yielded by the metal foil with a carrier obtained with the present invention, and this metal foil with a carrier is particularly effective for producing a printed circuit board.

## Claims

1. A metal foil B (1,3,7) with a carrier A (2,4,8), wherein the metal foil B (1,3,7) with a carrier A (2,4,8) comprises a structure where the carrier A (2,4,8) has an area which covers the entire surface of the metal foil B (1,3,7), the edge of the carrier A (2,4,8) protrudes partially or entirely from the metal foil B (1,3,7), **characterized in that** the carrier A (2,4,8) is made of a metal foil and the metal foil B is subject to ultrasonic bonding so as to come in contact with the metal foil carrier A.

2. The metal foil B (1,3,7) with carrier A (2,4,8) according to claim 1, wherein the carrier A is made of aluminum or copper or copper alloy.

3. The metal foil B (1,3,7) with carrier A (2,4,8) according to claim 1, wherein a glossy surface of the metal foil B is subject to ultrasonic bonding so as to come in contact with the metal foil carrier A.

4. The metal foil B (1,3,7) with carrier A (2,4,8) according to claim 1, 2 or 3, wherein the amount of protrusion of the edge of the carrier A (2,4,8) from the metal foil B (1,3,7) is 1 cm or greater.

5. The metal foil B (1,3,7) with carrier A (2,4,8) according to claim 1, 2 or 3, wherein the amount of protrusion of the edge of the carrier A (2,4,8) from the metal foil B (1,3,7) is approximately 1 cm to 10 cm.

6. The metal foil B (1,3,7) with carrier A (2,4,8) according to any one of claims 1 to 5, wherein the glossy surface of the metal foil B (1,3,7) is bonded to a roughened or a rough surface of the carrier A (2,4,8).

7. The metal foil B (1,3,7) with carrier A (2,4,8) according to any preceding claim, wherein the carrier A (2,4,8) and the metal foil B (1,3,7) are rectangular.

8. The metal foil B (1,3,7) with carrier A (2,4,8) according to any preceding claim, wherein:
one side of the carrier A (2,4,8) and one side of the metal foil B (1,3,7) are mutually aligned; or
two adjacent sides or two opposing sides of the carrier A (2,4,8) and the metal foil B (1,3,7) are mutually aligned; or
three sides each of the carrier A (2,4,8) and the metal foil B (1,3,7) are aligned.

9. The metal foil B (1,3,7) with carrier A (2,4,8) according to any one of claims 1 to 8, wherein the metal foil B (1,3,7) is a copper foil or a copper alloy foil.

10. The metal foil B with carrier A according to claim 1 , wherein the carrier A is a rolled copper foil or an electrolytic copper foil, and the glossy surface of the metal foil B is subject to ultrasonic bonding so as to come in contact with a roughened surface of the rolled copper foil carrier A or a rough surface or a roughened surface of the electrolytic copper foil carrier A.

11. The metal foil B with carrier A according to any preceding claim, wherein the carrier A and the metal foil B respectively have a glossy surface, and are laminated so that the respective glossy surfaces mutually face each other.

12. A laminate comprising the metal foil B (1,3,7) with carrier A (2,4,8) according to any one of claims 1 to 11 and a prepreg, preferably further comprising a core material or a two-layer printed circuit board.

13. The metal foil B with carrier A according to any one of claims 1 to 11, wherein the metal foil is an electrolytic foil with a thickness of 5 to 120 µm.

14. The metal foil B with carrier A according to any to any one of claims 1 to 11, wherein the metal foil is a rolled foil with a thickness of 5 to 120 µm.

15. The metal foil B with carrier A according to any one of claims 1 to 11, wherein the coefficient of thermal expansion of the carrier is within the range of +10% and -30% of the coefficient of thermal expansion of the metal foil.

## Patentansprüche

1. Metallfolie B (1, 3, 7) mit einem Träger A (2, 4, 8), worin die Metallfolie B (1, 3, 7) mit einem Träger A (2, 4, 8) eine Struktur umfasst, wobei der Träger A (2, 4, 8) einen Bereich aufweist, der die gesamte Oberfläche der Metallfolie B (1, 3, 7) abdeckt, wobei die Kante des Trägers A (2, 4, 8) teilweise oder ganz über die Metallfolie B (1, 3, 7) hervorsteht, **dadurch gekennzeichnet, dass** der Träger A (2, 4, 8) aus einer Metallfolie besteht und die Metallfolie B dem Ultraschallbonden unterzogen wird, um mit dem Metallfolienträger A in Kontakt zu kommen.

2. Metallfolie B (1, 3, 7) mit Träger A (2, 4, 8) nach Anspruch 1, worin der Träger A aus Aluminium oder Kupfer oder Kupferlegierung besteht.

3. Metallfolie B (1, 3, 7) mit Träger A (2, 4, 8) nach Anspruch 1, worin eine glänzende Oberfläche der Metallfolie B dem Ultraschallbonden unterzogen wird, um mit dem Metallfolienträger A in Kontakt zu kommen.

4. Metallfolie B (1, 3, 7) mit Träger A (2, 4, 8) nach Anspruch 1, 2 oder 3, worin der Betrag des Vorstehens der Kante des Trägers A (2, 4, 8) über die Metallfolie B (1, 3, 7) 1 cm oder größer ist.

5. Metallfolie B (1, 3, 7) mit Träger A (2, 4, 8) nach Anspruch 1, 2 oder 3, worin der Betrag des Vorstehens der Kante des Trägers A (2, 4, 8) über die Metallfolie B (1, 3, 7) ungefähr 1 cm bis 10 cm lautet.

6. Metallfolie B (1, 3, 7) mit Träger A (2, 4, 8) nach irgendeinem der Ansprüche 1 bis 5, worin die glänzende Oberfläche der Metallfolie B (1, 3, 7) an eine angeraute oder eine raue Oberfläche des Trägers A (2, 4, 8) gebondet ist.

7. Metallfolie B (1, 3, 7) mit Träger A (2, 4, 8) nach irgendeinem vorhergehenden Anspruch, worin der Träger A (2, 4, 8) und die Metallfolie B (1, 3, 7) rechteckig sind.

8. Metallfolie B (1, 3, 7) mit Träger A (2, 4, 8) nach irgendeinem vorhergehenden Anspruch, worin:
eine Seite des Trägers A (2, 4, 8) und eine Seite der Metallfolie B (1, 3, 7) zueinander ausgerichtet sind; oder
zwei benachbarte Seiten oder zwei gegenüberliegende Seiten des Trägers A (2, 4, 8) und der Metallfolie B (1, 3, 7) zueinander ausgerichtet sind; oder
jeweils drei Seiten des Trägers A (2, 4, 8) und der Metallfolie B (1, 3, 7) ausgerichtet sind.

9. Metallfolie B (1, 3, 7) mit Träger A (2, 4, 8) nach irgendeinem der Ansprüche 1 bis 8, worin die Metallfolie B (1, 3, 7) eine Kupferfolie oder eine Kupferlegierungsfolie ist.

10. Metallfolie B mit Träger A nach Anspruch 1, worin der Träger A eine gewalzte Kupferfolie oder eine elektrolytische Kupferfolie ist und die glänzende Oberfläche der Metallfolie B dem Ultraschallbonden unterzogen wird, um mit einer angerauten Oberfläche des gewalzten Kupferfolienträgers A oder einer rauen Oberfläche oder einer angerauten Oberfläche des elektrolytischen Kupferfolienträgers A in Kontakt zu kommen.

11. Metallfolie B mit Träger A nach irgendeinem vorhergehenden Anspruch, worin der Träger A und die Metallfolie B jeweils eine glänzende Oberfläche aufweisen und laminiert sind, sodass die jeweiligen glänzenden Oberflächen einander gegenüberstehen.

12. Laminat umfassend die Metallfolie B (1, 3, 7) mit Träger A (2, 4, 8) nach irgendeinem der Ansprüche 1 bis 11 und einen Prepreg, vorzugsweise ferner umfassend ein Kernmaterial oder eine zweilagige gedruckte Leiterplatte.

13. Metallfolie B mit Träger A nach irgendeinem der Ansprüche 1 bis 11, worin die Metallfolie eine elektrolytische Folie mit einer Dicke von 5 bis 120 µm ist.

14. Metallfolie B mit Träger A nach irgendeinem der Ansprüche 1 bis 11, worin die Metallfolie eine gewalzte Folie mit einer Dicke von 5 bis 120 µm ist.

15. Metallfolie B mit Träger A nach irgendeinem der Ansprüche 1 bis 11, worin der Wärmeausdehnungskoeffizient des Trägers innerhalb des Bereichs von +10 % bis -30 % des Wärmeausdehnungskoeffizienten der Metallfolie liegt.

## Revendications

1. Feuille métallique B (1, 3, 7) avec support A (2, 4, 8), la feuille métallique B (1, 3, 7) avec support A (2, 4, 8) comprenant une structure dans laquelle le support A (2, 4, 8) comporte une région qui couvre la surface entière de la feuille métallique B (1, 3, 7), et dans laquelle le bord du support A (2, 4, 8) dépasse partiellement ou totalement de la feuille métallique B (1, 3, 7), **caractérisée en ce que** le support A (2, 4, 8) est constitué d'une feuille métallique et **en ce que** la feuille métallique B est soumise à un soudage par ultrasons de manière à venir en contact avec le support de feuille métallique A.

2. Feuille métallique B (1, 3, 7) avec support A (2, 4, 8) selon la revendication 1, dans laquelle le support A est en aluminium ou en cuivre ou en alliage de cuivre.

3. Feuille métallique B (1, 3, 7) avec support A (2, 4, 8) selon la revendication 1, dans laquelle une surface brillante de la feuille métallique B est soumise à un soudage par ultrasons de manière à venir en contact avec le support de feuille métallique A.

4. Feuille métallique B (1, 3, 7) avec support A (2, 4, 8) selon la revendication 1, 2 ou 3, dans laquelle le bord du support A (2, 4, 8) dépasse de la feuille métallique B (1, 3, 7) d'une valeur supérieure ou égale à 1 cm.

5. Feuille métallique B (1, 3, 7) avec support A (2, 4, 8) selon la revendication 1, 2 ou 3, dans laquelle le bord du support A (2, 4, 8) dépasse de la feuille métallique B (1, 3, 7) d'une valeur d'environ 1 cm à 10 cm.

6. Feuille métallique B (1, 3, 7) avec support A (2, 4, 8) selon l'une quelconque des revendications 1 à 5, dans laquelle la surface brillante de la feuille métallique B (1, 3, 7) est soudée à une surface rugueuse ou rendue rugueuse du support A (2, 4, 8).

7. Feuille métallique B (1, 3, 7) avec support A (2, 4, 8) selon l'une quelconque des revendications précédentes, dans laquelle le support A (2, 4, 8) et la feuille métallique B (1, 3, 7) sont rectangulaires.

8. Feuille métallique B (1, 3, 7) avec support A (2, 4, 8) selon l'une quelconque des revendications précédentes, dans laquelle :
un côté du support A (2, 4, 8) et un côté de la feuille métallique B (1, 3, 7) sont mutuellement alignés ; ou
deux côtés adjacents ou deux côtés opposés du support A (2, 4, 8) et de la feuille métallique B (1, 3, 7) sont mutuellement alignés ; ou
trois côtés chacun du support A (2, 4, 8) et de la feuille métallique B (1, 3, 7) sont alignés.

9. Feuille métallique B (1, 3, 7) avec support A (2, 4, 8) selon l'une quelconque des revendications 1 à 8, la feuille métallique B (1, 3, 7) étant une feuille de cuivre ou une feuille d'alliage de cuivre.

10. Feuille métallique B avec support A selon la revendication 1, dans laquelle le support A est une feuille de cuivre laminée ou une feuille de cuivre électrolytique, et dans laquelle la surface brillante de la feuille métallique B est soumise à un soudage par ultrasons de manière à venir en contact avec une surface rendue rugueuse du support de feuille de cuivre laminée A ou une surface rugueuse ou rendue rugueuse du support de feuille de cuivre électrolytique A.

11. Feuille métallique B avec support A selon l'une quelconque des revendications précédentes, le support A et la feuille métallique B ayant respectivement une surface brillante et étant laminés de sorte que les surfaces brillantes respectives soient mutuellement face à face.

12. Plaqué comprenant la feuille métallique B (1, 3, 7) avec support A (2, 4, 8) selon l'une quelconque des revendications 1 à 11 et un préimprégné, de préférence comprenant en outre un matériau de noyau ou une carte de circuit imprimé à deux couches.

13. Feuille métallique B avec support A selon l'une quelconque des revendications 1 à 11, la feuille métallique étant une feuille électrolytique d'une épaisseur de 5 à 120 µm.

14. Feuille métallique B avec support A selon l'une quelconque des revendications 1 à 11, la feuille métallique étant une feuille laminée d'une épaisseur de 5 à 120 µm.

15. Feuille métallique B avec support A selon l'une quelconque des revendications 1 à 11, dans laquelle le coefficient de dilatation thermique du support est de l'ordre de +10 % et -30 % du coefficient de dilatation thermique de la feuille métallique.
